# EUROPÄISCHE PATENTSCHRIFT

(11) **EP 0 417 334 B1**
(45) Veröffentlichungstag und Bekanntmachung des Hinweises auf die Patenterteilung: **29.12.1993**
(21) Anmeldenummer: 89116799.1
(22) Anmeldetag: 11.09.1989
(51) Int. Cl.: H03K 3/297

(54) **Kippschaltung mit Schalthysterese**
Latch circuit with switching hysterisis
Circuit de bascule avec hystérésis de commutation

(43) Veröffentlichungstag der Anmeldung: 20.03.1991
(73) Patentinhaber: SIEMENS AKTIENGESELLSCHAFT, 80333 München (DE)
(72) Erfinder: Barré, Claude, Dipl.-Ing., D-8000 München 70 (DE)

(56) Entgegenhaltungen:
- EP-A- 0 067 441
- EP-A- 0 131 205
- EP-A- 0 305 941
- US-A- 3 074 020
- PATENT ABSTRACTS OF JAPAN, Band 12, Nr. 322 (E-652)[3169], 31st August 1988; & JP-A-63 86 611 (NEC CORP.) 18-04-1988

## Beschreibung

Die Erfindung betrifft eine Kippschaltung mit Schalthysterese.

Den Eingängen von Digitalschaltungen, beispielsweise von Gate-Arrays, sind häufig Kippschaltungen mit Schalthysterese vorgeschaltet, um zum einen die Störsicherheit insbesondere im Bereich der Schaltschwelle zu erhöhen und zum anderen um auch Eingangssignale mit langsameren Flanken verarbeiten zu können. Bevorzugte Kippschaltungen mit Schalthysterese, auch Schmitt-Trigger genannt, sind beispielsweise aus U. Tietze, Ch. Schenk, Halbleiter-Schaltungstechnik, 5. Auflage 1980, Seite 135 bekannt. Dabei handelt es sich um ein emittergekoppeltes, im wesentlichen mit einem konstanten Emitterstrom betriebenes Transistorpaar, in dessen Lastkreis sich jeweils ein Lastwiderstand befindet und das durch einen Spannungsteiler zwischen einem der beiden Lastkreise und dem entsprechenden Eingangskreis mitgekoppelt ist. Durch geeignete Dimensionierung der Schaltung kann erreicht werden, daß beim Umkippen der konstante Emitterstrom von einem Transistor auf den anderen wechselt, ohne daß das Transistorpaar in Sättigung gerät. Dadurch ergeben sich beim Umschalten keine Speichereffekte und es können wesentliche höhere Schaltfrequenzen erreicht werden.

Gerade bei Gate-Arrays, wie aber auch bei zahlreichen anderen Digitalschaltungen, kommt es häufig vor, daß die den logischen Zuständen zugeordneten Signalpegel innerhalb der Schaltungen nicht mit dem Signalpegel am Eingang übereinstimmen und eine Pegelumsetzung also nötig ist. Darüber hinaus ist in vielen Fällen eine Anpassung des Hystereseverlaufs an das Verhalten des Eingangssignals notwendig. Bei der bekannten Kippschaltung können jedoch Sättigungsgrad der Transistoren, Ausgangssignalpegel und Hystereseverlauf nicht unabhängig voneinander eingestellt werden, wodurch ein Justieren der Kippschaltung problematisch ist.

Aufgabe der Erfindung ist es daher, eine Kippschaltung mit Schalthysterese anzugeben, bei der der Sättigungsgrad der Transistoren, der Ausgangssignalpegel und der Hystereseverlauf unabhängig voneinander eingestellt werden können.

Die Aufgabe wird bei einer Kippschaltung der eingangs genannten Art durch die Merkmale des Patentanspruches 1 gelöst.

Ausgestaltungen des Erfindungsgedankens sind in abhängigen Ansprüchen gekennzeichnet.

Vorteile der Erfindung sind, daß die Kippschaltung mit verschiedenen Arten von Logik kombiniert werden kann, daß differentielle Eingänge realisierbar sind und daß der interne und externe Signalpegel unterschiedlich sein können.

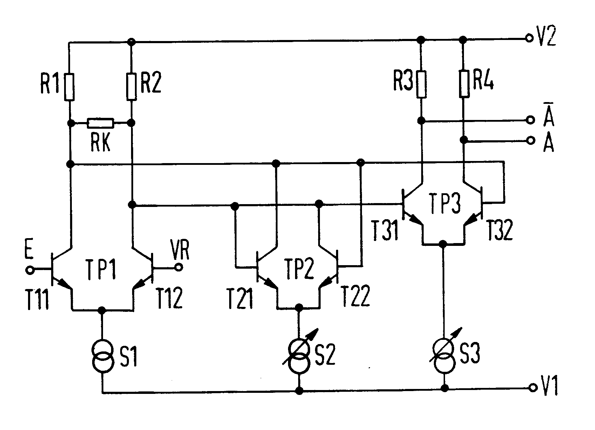

Die Erfindung wird nachfolgend anhand des in der einzigen Figur der Zeichnung dargestellten Ausführungsbeispiels näher erläutert.

Das Ausführungsbeispiel zeigt erfindungsgemäß ein emittergekoppeltes und aus einer ersten Stromquelle S1 gespeistes erstes Transistorpaar TP1 mit einem ersten und einem zweiten npn-Transistor T11 und T12. Die Basis des ersten npn-Transistors T11 ist den ersten Eingangskreis bildend mit einem Eingangssignal E und die Basis des zweiten npn-Transistors T12 ist den zweiten Eingangskreis bildend mit einem Referenzpotential VR beaufschlagt. In die beiden Lastkreise des ersten Transistorpaares TP1 sind jeweils Lastwiderstände R1 und R2 geschaltet. Dabei verbindet der Lastwiderstand R1 den Kollektor des ersten npn-Transistors T11 und der Lastwiderstand R2 den Kollektor des zweiten npn-Transistors T12 mit einem Versorgungspotential V2. Beide Lastkreise sind über einen Koppelwiderstand RK zur Sättigungsverhinderung miteinander verbunden, indem dieser zwischen die Kollektoren von erstem und zweiten npn-Transistor T11 und T12 geschaltet ist. An Stelle der gezeigten Dreiecksschaltung von Lastwiderständen R1, R2 und Koppelwiderstand RK ist in gleicher Weise auch eine Sternschaltung möglich.

Weiterhin zeigt das Ausführungsbeispiel ein Emitter-gekoppeltes und aus einer zweiten Stromquelle S2 gespeistes zweites Transistorpaar TP2 mit einem dritten und vierten npn-Transistor T21 und T22. Die Lastkreise des zweiten Transistorpaares TP2 sind direkt und dessen Eingangskreise über Kreuz mit den entsprechenden Lastkreisen des ersten Transistorpaares TP1 gekoppelt. Damit ist aber die Basis des dritten npn-Transistors T21 und der Kollektor des vierten npn-Transistors T22 mit dem Kollektor des zweiten npn-Transistors T12 sowie die Basis des vierten npn-Transistors T22 und der Kollektor des dritten npn-Transistors T21 mit dem Kollektor des ersten npn-Transistors T11 verbunden.

Schließlich ist ein emittergekoppeltes und aus einer dritten Stromquelle S3 gespeistes drittes Transistorpaar TP3 mit einem fünften und sechsten npn-Transistor T31 und T32 vorgesehen, in dessen Lastkreis jeweils weitere Lastwiderstand R3 und R4 ge schaltet sind und dessen Eingangskreise mit den entsprechenden Lastkreisen des ersten Transistorpaares TP1 gekoppelt sind. Dazu ist die Basis des fünften npn-Transistors T31 mit dem Kollektor des zweiten npn-Transistors T12 und die Basis des sechsten npn-Transistors T32 mit dem Kollektor des ersten npn-Transistors T11 verbunden. Die Kollektoren von fünften und sechstem npn-Transistor T31 und T32 sind über den Lastwiderstand R3 bzw. R4 mit dem Versorgungspotential V2 beaufschlagt. Am Kollektor des sechsten npn-Transistors T32 liegt dabei ein Ausgangssignal A und am Kollektor des fünften npn-Transistors T31 ein dazu invertiertes Ausgangssignal A̅ an.

Die Stromquellen S1, S2 und S3 sind jeweils zwischen die gekoppelten Emitter der Transistorpaare TP1, TP2, TP3 und einem ersten Versorgungspotential V1 geschaltet. In Ausgestaltung der Erfindung sind dabei die Stromquellen S2 und S3 als extern veränderbare Stromquellen ausgeführt. Ebenso ist auch das Referenzpotential VR extern veränderbar. Der Vorteil dabei ist eine veränderbare Anpassung an verschiedene Eingangs- und Ausgangssignalpegel.

Die Einstellung des Eingangs-Hysterese-Pegels erfolgt durch Ändern der Referenzspannung VR. Die Hysteresebreite wird dabei von dem Verhältnis des Stromes der zweiten Stromquelle S2 zum Strom der ersten Stromquelle S1 bestimmt. Der Ausgangspegel der Kippschaltung wird durch den von der dritten Stromquelle S3 abgegebenen Strom festgelegt. Unberührt davon bleibt allen Einstellungen die Sättigungsfreiheit der Schaltung, die durch die Lastwiderstände R1, R2 in Verbindung mit dem Koppelwiderstand RK festgelegt ist.

## Patentansprüche

1. Kippschaltung mit Schalthysterese mit einem emittergekoppelten und aus einer ersten Stromquelle (S1) gespeisten ersten Transistorpaar (TP1), in dessen Lastkreise jeweils Lastwiderstände (R1, R2) geschaltet sind, dessen Lastkreise über einen Koppelwiderstand (RK) miteinander verbunden sind, dessen erster Eingangskreis mit einem Eingangssignal (E) und dessen zweiter Eingangskreis mit einem Referenzpotential (VR) beaufschlagt ist,
mit einem emittergekoppelten und aus einer zweiten Stromquelle (S2) gespeisten zweiten Transistorpaar (TP2), dessen Lastkreise direkt und dessen Eingangskreise über Kreuz mit den entsprechenden Lastkreisen des ersten Transistorpaares (TP1) gekoppelt sind und
mit einem emittergekoppelten und aus einer dritten Stromquelle (S3) gespeisten dritten Transistorpaar (TP3), in dessen Lastkreise jeweils weitere Lastwiderstände (R3, R4) geschaltet sind und dessen Eingangskreise mit den entsprechenden Lastkreisen des ersten Transistorpaares (TP1) gekoppelt sind.

2. Kippschaltung nach Anspruch 1,
**dadurch gekennzeichnet,** daß das Referenzpotential (VR) veränderbar ist.

3. Kippschaltung nach Anspruch 1 oder 2,
**dadurch gekennzeichnet,** daß bei der dritten Stromquelle (S3) der eingeprägte Strom veränderbar ist.

4. Kippschaltung nach Anspruch 1, 2 oder 3,
**dadurch gekennzeichnet,** daß bei der ersten Stromquelle (S1) oder bei der zweiten Stromquelle (S2) oder bei beiden der eingeprägte Strom veränderbar ist.

## Claims

1. Trigger circuit having switching hysteresis, comprising an emitter-coupled first transistor pair (TP1) which is supplied from a first current source (S1), in whose load circuits load resistors (R1, R2) are connected in each case, whose load circuits are connected together by means of a coupling resistor (RK), to whose first input circuit an input signal (E) is applied and to whose second input circuit a reference potential (VR) is applied,
comprising an emitter-coupled second transistor pair (TP2) which is supplied from a second current source (S2), whose load circuits are directly coupled to the corresponding load circuits of the first transistor pair (TP1) and whose input circuits are crosswise coupled to the corresponding load circuits of the first transistor pair (TP1), and
comprising an emitter-coupled third transistor pair (TP3) which is fed from a third current source (S3), in whose load circuits further load resistors (R3, R4) are connected in each case, and whose input circuits are coupled to the corresponding load circuits of the first transistor pair (TP1).

2. Trigger circuit according to Claim 1, characterized in that the reference potential (VR) is adjustable.

3. Trigger circuit according to Claim 1 or 2, characterized in that, in the case of the third current source (S3), the impressed current is adjustable.

4. Trigger circuit according to Claim 1, 2 or 3, characterized in that, in the case of the first current source (S1) or in the case of the second current source (S2) or in the case of both of them, the impressed current is adjustable.

## Revendications

1. Circuit à bascule présentant une hystérésis de commutation et
comportant un premier couple de transistors (TP1), qui sont montés à émetteurs couplés et qui sont alimentés par une première source de courant (S1), et dans les circuits de charge desquels sont branchées respectivement des résistances de charge (R1,R2), et dont les circuits de charge sont reliés entre eux par l'intermédiaire d'une résistance de couplage (RK), dont le premier circuit d'entrée est chargé par un signal d'entrée (E) et dont le second circuit d'entrée est chargé par un potentiel de référence (VR),
comportant un deuxième couple de transistors (TP2) qui sont montés à émetteurs couplés et qui sont alimentés par une troisième source de courant (S2), dont les circuits de charge sont couplés directement et dont les circuits d'entrée sont couplés d'une manière croisée avec les circuits de charge correspondants du premier couple de transistors (TP1), et
comportant un troisième couple de transistors (TP3) qui sont montés à émetteurs couplés et qui sont alimentés par une troisième source de courant (S3), dans les circuits de charge desquels sont branchées respectivement d'autres résistances de charge (R3,R4) et dont les circuits d'entrée sont couplés aux circuits de charge correspondants du premier couple de transistors (TP1).

2. Circuit à bascule suivant la revendication 1, caractérisé par le fait que le potentiel de référence (VR) est variable.

3. Circuit à bascule suivant la revendication 1 ou 2, caractérisé par le fait que, dans la troisième source de courant (S3), le courant injecté est variable, .

4. Circuit à bascule suivant la revendication 1, 2 ou 3, caractérisé par le fait que, dans la première source de courant (S1) ou dans la seconde source de courant (S2) ou dans ces deux sources de courant, le courant injecté est variable.
